# EUROPÄISCHE PATENTANMELDUNG

(11) **EP 1 209 743 A2**
(43) Veröffentlichungstag der Anmeldung: **29.05.2002**
(21) Anmeldenummer: 01126264.9
(22) Anmeldetag: 06.11.2001
(51) Int. Cl.: H01L 23/495

(54) **Leiterstreifenanordnung für ein gemouldetes elektronisches Bauelement und Verfahren zum Moulden**

(30) Priorität: 25.11.2000 DE 10058608
(71) Anmelder: Vishay Semiconductor GmbH, 74072 Heilbronn (DE)
(72) Erfinder: Scheidle, Helmut, 74196 Neuenstadt (DE)
(74) Vertreter: Kolb, Georg

(57) **Zusammenfassung**

1. Leiterstreifenanordnung für ein gemouldetes elektronisches Bauelement und Verfahren zum Moulden
2.1. Bei gemouldeten elektronischen Bauelementen verbleibt in der Trennebene des Mouldwerkzeugs ein Grat (Ridge) aus Mouldwerkstoff. Besonders nachteilig wirkt sich dies aus, wenn der Grat durch eine Fläche des Gehäuses führt, an der eine Saugnadel andockt.
2.2. Herstellverfahren und Leiterstreifenanordnung für ein gemouldetes elektronisches Bauelement, wobei auf einem elektrisch leitfähigen Leiterstreifen wenigstens ein Halbleiterbauelement angeordnet ist und um den Leiterstreifen und das wenigstens eine Halbleiterbauelement ein Gehäuse aus einem Mouldwerkstoff derart angeordnet ist, dass sich noch Teile des Leiterstreifens außerhalb des Gehäuses befinden. Kennzeichnend ist, dass Teile des Leiterstreifens in Bereichen vergrößert sind, so dass diese vergrößerten Bereiche an das spätere Gehäuse direkt angrenzen oder in das Gehäuse hinein ragen, um die Bildung eines Grats zu verhindern.
2.3. Die Erfindung eignet sich insbesondere zur Herstellung von gemouldeten elektronischen Bauelementen, bei denen die Trennebene durch diejenige Gehäusefläche verläuft, an der eine Saugnadel andockt.

## Beschreibung

Die Erfindung betrifft eine Leiterstreifenanordnung für ein gemouldetes elektronisches Bauelement und ein Verfahren zum Moulden nach den Oberbegriffen der Patentansprüche 1 und 5.

Ein solches elektronisches Bauelement ist beispielsweise aus der deutschen Offenlegungsschrift DE 196 53 054 A1 bekannt. Bei solchen elektronischen Bauelementen werden Halbleiterchips (optoelektronischer Sender und Empfänger, Integrierter Schaltkreis zur Signalaufbereitung) erst maschinell auf einen metallenen Leiterstreifen geklebt oder gelötet und danach mittels dünner Gold- oder Aluminiumdrähte miteinander und mit dem Leiterstreifen kontaktiert. Danach werden Halbleiterchips und Leiterstreifen in den meisten Fällen durch ein Mouldverfahren mit einem thermoplastischen Kunststoff, beispielsweise einem Kunstharz, umhüllt und dadurch ein Gehäuse zum Schutz dieser Baugruppe hergestellt.

Bei der Herstellung des Gehäuses verbleibt in der Trennebene der Mouldform zwischen dem Ober- und Unterteil ein Grat oder Vorsprung aus dem Mouldwerkstoff, für den auch die englische Bezeichnung "Ridge" verwendet wird. Besonders nachteilig wirkt sich dies aus, wenn der Grat durch diejenige Fläche des Gehäuses führt, an der zu einem späteren Zeitpunkt eine Saugnadel eines Bestückungsautomats angedockt wird, um das Bauelement aufzunehmen und es beispielsweise auf einer Leiterplatte zu plazieren. Bedingt durch den Grat schließt die Saugnadel nicht dicht ab, sondern zieht sehr viel Fremdluft, wodurch ein aufzunehmendes Bauelement nicht kräftig genug angezogen und damit gehalten wird. Zudem kippt das Bauelement beim Aufnehmen und nimmt an der Saugnadel eine verkantete und undefinierbare Position ein. Aus diesen Gründen gehen beim Transport unannehmbar viele Bauelemente verloren oder werden ungenau plaziert.

Man versucht daher, den Grat (Ridge) so klein als möglich zu halten, was aber Mouldwerkzeuge mit sehr engen Toleranzen, eine sehr präzise Fertigung und zusätzliche Kontrollen erfordert. Diese Maßnahmen bedeuten aber merklich erhöhte Herstellkosten, ohne dass das Problem wirklich gelöst ist.

Der Erfindung liegt die Aufgabe zugrunde, eine Leiterstreifenanordnung für ein gemouldetes elektronisches Bauelement nach dem Oberbegriff des Anspruchs 1 so zu gestalten, dass das elektronische Bauelement ohne Schwierigkeiten von einer Bestückungsmaschine aufgenommen und plaziert werden kann. Es ist weiterhin Aufgabe der Erfindung, ein Verfahren zum Moulden eines solchen elektronischen Bauelements anzugeben.

Gelöst wird diese Aufgabe durch eine im Anspruch 1 angegebenes Leiterstreifenanordnung und ein Verfahren zum Moulden mit den im Anspruch 5 angegebenen Merkmalen.

Nach dem Verfahren des Anspruchs 5 hergestellte elektronische Bauelemente weisen den Vorteil auf, dass sie von automatischen Bestückungsmaschinen problemlos aufgenommen, sicher gehalten und exakt plaziert werden können, ohne dass bei der Herstellung der elektronischen Bauelemente besonders enge Toleranzen eingehalten oder dass zur Herstellung besondere Werkzeuge verwendet werden müssen.

Die Erfindung eignet sich insbesondere zur Herstellung von elektronischen Bauelementen, bei denen die Trennebene durch diejenige Gehäusefläche verläuft, an die die Saugnadel einer Bestückungsmaschine andockt.

Vorteilhafte Ausgestaltungen der Leiterstreifenanordnung nach Anspruch 1 und des Verfahrens zum Moulden nach Anspruch 5 sind in den Unteransprüchen angegeben.

Die Erfindung wird nun anhand eines Ausführungsbeispiels unter Zuhilfenahme der Zeichnung erläutert. Es zeigen
- Fig. 1:: eine Draufsicht auf eine Baugruppe, bestehend aus einem Leiterstreifen, der bereits mit kontaktierten Halbleiterbauelementen bestückt ist,
- Fig. 2a:: eine Draufsicht auf ein elektronisches Bauelement, das die Baugruppe nach Fig. 1 beinhaltet und zusätzlich mit einem Gehäuse versehen ist,
- Fig. 2b:: eine Seitenansicht auf das elektronische Bauelement nach Fig. 2a,
- Fig. 3:: eine Seitenansicht des elektronischen Bauelements nach Fig. 2a und 2b bei einem nachfolgenden Fertigungsschritt,
- Fig. 4:: das nach dem erfindungsgemäßen Verfahren fertig gestellte elektronische Bauelement und
- Fig. 5:: ein elektronisches Bauelement nach dem Stand der Technik.

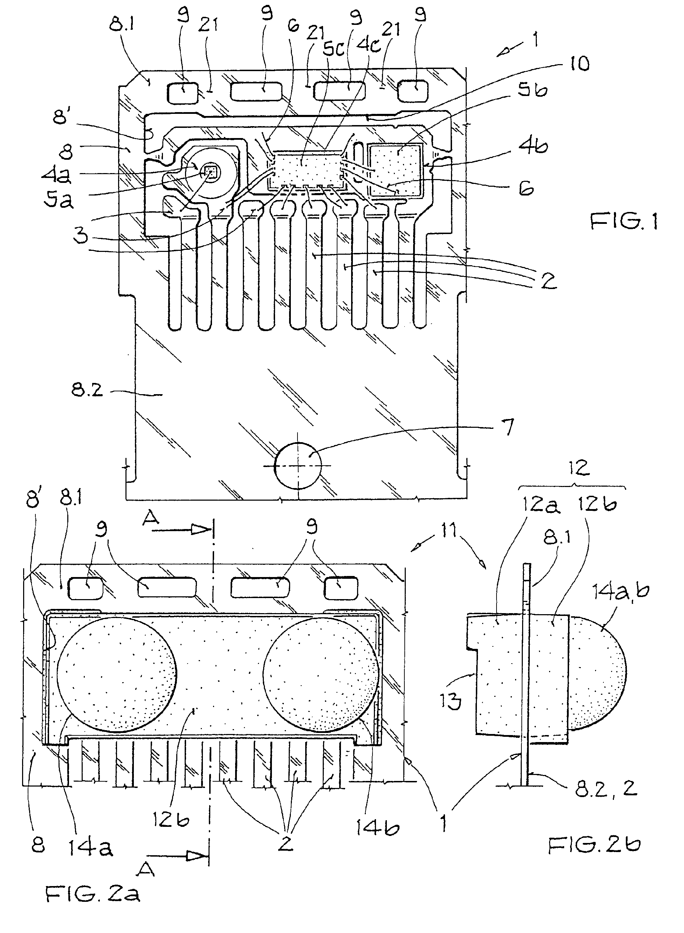

Die **Fig. 1** zeigt einen Leiterstreifen **1,** der beispielsweise aus einer Kupferlegierung besteht und auf bekannte Art und Weise aus einem dünnen Blech herausgestanzt oder herausgeätzt wird. Ebenfalls durch Stanzen oder Ätzen werden Anschlussbeinchen **2** mit Bondflächen **3** und Bestückungsflächen **4a, 4b** und **4c** für elektronische oder optoelektronische Halbleiterbauelemente **5a, 5b** und **5c** ausgeformt. Die Halbleiterbauelemente **5a, 5b** und **5c** werden mittels eines Haftstoffes wie beispielsweise eines Lotes oder eines leitfähigen Klebstoffes stoffschlüssig auf den Bestückungsflächen **4a, 4b** und **4c** des Leiterstreifens **1** befestigt.

Bei dem Halbleiterbauelement **5a** handelt es sich beispielsweise um einen optoelektronischen Sender (Transmitter), bei dem Halbleiterbauelement **5b** beispielsweise um einen optoelektronischen Empfänger (Receiver) und bei dem Halbleiterbauelement **5c** beispielsweise um einen Integrierten Schaltkreis zum Aufbereiten der vom optoelektronischen Empfänger **5b** abgegebenen elektrischen Signale. Die Halbleiterbauelemente **5a, 5b** und **5c** sind mittels dünner Bonddrähte **6** aus einer Aluminium- oder Goldlegierung untereinander bzw. mit den Bondflächen **3** der Anschlussbeinchen **2** verbunden.

Weiterhin weist der Leiterstreifen **1** einen Rahmen **8** mit einer inneren Begrenzung **8'** und Rahmenteilen **8.1** und **8.2** auf. In den Rahmenteil **8.2** ist eine Positionier- und Transportöffnung **7** in Form eines Rundloches eingebracht, und in den Rahmenteil **8.1** sind Öffnungen **9** in Form von Langlöchern eingebracht, wobei zwischen den Öffnungen **9** Stege **21** angeordnet sind. Zudem weist der Rahmenteil **8.1** eine Verbreiterung **10** auf. Sinn und Zweck der Öffnungen **9,** der Stege **21** und der eine Verbreiterung **10** werden weiter unten beschrieben.

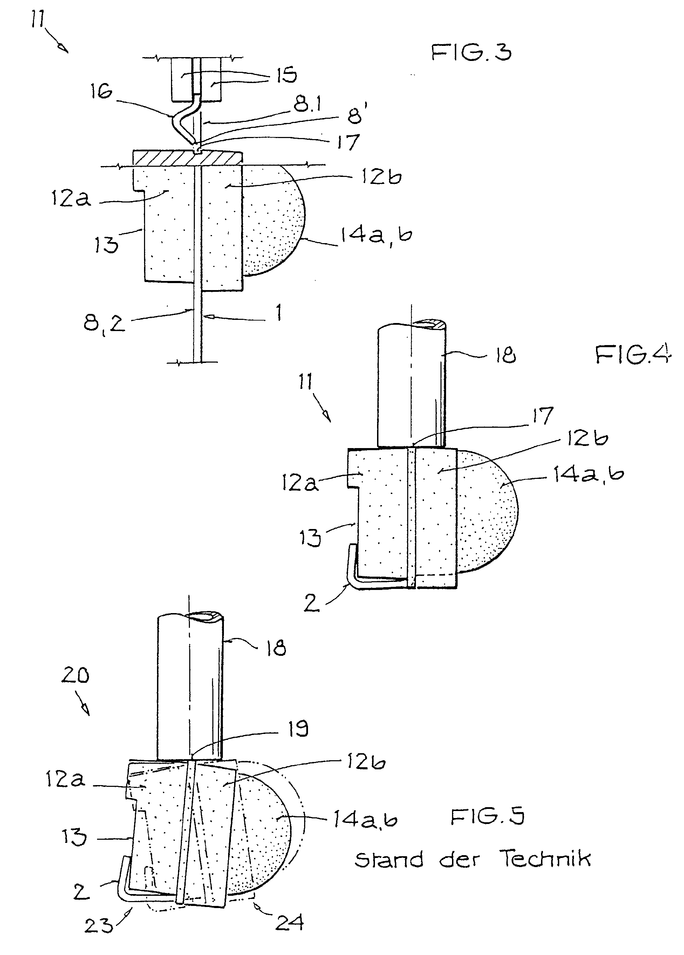

Der Rahmen **8** befindet sich beim Mouldvorgang zwischen Ober- und Unterteil der Mouldform. Seine innere Begrenzung **8'** verläuft dabei um die eigentliche Mouldform, da er einen geringfügig größeren Durchmesser aufweist als das spätere, durch die Mouldform hergestellte Gehäuse **12** (Fig. 2a, b).

Die Fig. **2a** und **2b** zeigen ein aus der Baugruppe der Fig. 1 bestehendes, noch nicht fertig gestelltes elektronisches Bauelement **11** zur gerichteten, bidirektionalen optischen Datenübertragung in einem späteren Stadium der Fertigung. Ein solches Bauelement **11** wird auch als Transceiver (aus **Trans**mitter und Re**ceiver**) bezeichnet. Die Halbleiterbauelemente **5a-c** (Fig. 1) und die Bonddrähte **9** (Fig. 1) wurden zur Herstellung eines schützenden Gehäuses **12** mittels eines Mouldverfahrens mit einem thermoplastischen und für einen bestimmten Wellenlängenbereich transparenten Kunststoff, beispielsweise mit einem Kunstharz, umhüllt.

Dabei besteht das Gehäuse **12** aus zwei Teilen: einem ersten Gehäuseteil **12a** mit einer Ausnehmung **13** (in die später die Anschlussbeinchen **2** hineinragen, Fig. 4) und einem zweiten Gehäuseteil **12b.** Aus der Trennebene zwischen den beiden Gehäuseteilen **12a** und **12b** ragen die noch nicht entfernten Teile des Leiterstreifens **1.** Beim ersten Gehäuseteil **12a** handelt es sich um die einer Leiterplatte zugewandte Seite (Bestückungsseite) des Bauelements **11;** der zweite Gehäuseteil **12b** enthält zwei Auswölbungen **14a** bzw. **14b,** die als Linsen vor dem Transmitter **5a** (Fig. 1) bzw. dem Receiver **5b** (Fig. 1) angeordnet sind.

**Fig. 3** zeigt eine Seitenansicht des elektronischen Bauelements **11** nach Fig. 2a und 2b bei einem nachfolgenden Fertigungsschritt. Nicht mehr benötigte Teile des Leiterstreifens **1** werden durch Stanzen oder Schneiden entfernt und somit beispielsweise die Anschlussbeinchen **2** auf ihre endgültige Länge gekürzt.

Bei Bauelementen nach dem Stand der Technik hat der Rahmen **8** des Leiterstreifens **1** einen Abstand zum Gehäuse **12,** weshalb sich beim Moulden an dieser Stelle ein Grat aus dem Mouldwerkstoff (Kunstharz) bildet, der später nur mit großem Aufwand verkleinert, nicht jedoch restlos entfernt werden kann und somit beim Aufnehmen durch eine Bestückungsmaschine große Schwierigkeiten bereitet (Fig. 5).

Die Erfindung hingegen sieht vor, dass der Rahmen **8** mit seiner inneren Begrenzung **8'** an den Bereich des späteren Gehäuses **12** direkt angrenzt oder etwas in den Bereich des späteren Gehäuses **12** hineinragt und somit die Bildung eines Grats an dieser Stelle verhindert; dazu dient die Verbreiterung **10** des Rahmenteils **8.1.**

Um das Bauelement **11** aus den noch nicht entfernten Teilen des Leiterstreifens **1** herausnehmen zu können, beispielsweise durch Ausdrücken mit einer kleinen Hebelpresse, ohne dass dies durch die möglicherweise in das Gehäuse **12** hineinragende Verbreiterung **10** des Leiterstreifens **1** verhindert oder das Gehäuse **12** dadurch beschädigt wird, wird der Leiterstreifen **1** im Bereich des Rahmenteils **8.1** von einer Haltevorrichtung **15** festgehalten und der Rahmenteil **8.1** mechanisch, beispielsweise durch Prägen, derart umgeformt, so dass eine Verformung **16,** beispielsweise wie dargestellt in Form einer V-förmigen Sicke, entsteht.

Es ist von Vorteil, wenn in den Rahmenteil **8.1** Öffnungen **9** in Form beispielsweise von Langlöchern eingebracht werden. Diese Langlöcher **9** schwächen das Material des Rahmenteils **8.1,** so dass die Verformung **16** mit verringertem Kraftaufwand und exakt entlang der Stege **21** zwischen diesen Langlöchern **9** hergestellt werden kann.

Durch das Herstellen der Verformung **16** wird der Rahmenteil **8.1** im Idealfall vom Gehäuse **12** weg bzw. im nicht idealen Fall aus dem Gehäuse **12** heraus gezogen, wodurch an dieser Stelle eine schmale und flache Vertiefung (Nut) **17** entsteht. Dem einschlägig vorgebildeten Fachmann ist es geläufig, statt der hier gezeigten V-förmigen Sicke beispielsweise eine U-förmige Sicke oder eine sonstige mechanische Verformung **16** in beliebiger Art und Weise derart herzustellen, dass sich der Rahmenteil **8.1** verformt und dadurch zwischen Rahmenteil **8.1** und Gehäuse **12** ein Zwischenraum entsteht.

Der Idealfall tritt ein, wenn sich die Verbreiterung **10** des Rahmenteils **8.1** und das Gehäuse **12** gerade noch berühren. Ist die Verbreiterung **10** des Rahmenteils **8.1** im nicht idealen Fall etwas breiter bzw. wird das Gehäuse **12** beim Moulden etwas versetzt oder etwas größer hergestellt, so ragt der Rahmenteil **8.1** mit der Verbreiterung **10** in geringem Maße in das Gehäuse **12** hinein. Bei der Herstellung der Verformung **16** entsteht dann durch das Herausziehen des Rahmenteils **8.1** aus dem Gehäuse **12** die genannte Vertiefung **17** im Gehäuse **12.**

Eine solche Vertiefung **17** stellt jedoch nur einen kleinen "Schönheitsfehler" dar und hat keine weiteren negativen Auswirkungen, da auch trotz einer Vertiefung **17** eine Saugnadel **18** (Fig. 4) bündig mit dem Gehäuse **12** abschließt und durch die Vertiefung **17,** die sich als dünne, flache und über die betreffende Fläche des Gehäuses **12** verlaufende Nut auswirkt, nur eine sehr geringe Menge Fremdluft gezogen wird. Das führt lediglich zu einer fast unmerklichen Verminderung der Kraft, mit der ein solches Bauelement **11** von der Saugnadel **18** (Fig. 4) angezogen wird. Eine Verkantung des Bauelements **11** unterbleibt jedoch.

In **Fig. 4** ist das nach dem erfindungsgemäßen Verfahren fertig gestellte elektronische Bauelement **11** dargestellt. Die Anschlussbeinchen **2** sind umgebogen und ragen in die Ausnehmung **13** hinein. Die restlichen, außerhalb des Gehäuses **12** angeordneten Teile des Leiterstreifens **1,** insbesondere der Rahmen **8,** sind entfernt. Die Saugnadel **18** eines (nicht dargestellten) Bestückungsautomaten kann jetzt ohne Schwierigkeiten das Bauelement **11** an der der Bestückungsseite gegenüberliegenden glatten Fläche des Gehäuses **12** durch Ansaugen aufnehmen, sicher festhalten und präzise beispielsweise auf einer Leiterplatte plazieren, ohne dass sich eine möglicherweise vorhandene Vertiefung **17** störend auswirkt.

Schließlich zeigt **Fig. 5** ein elektronisches Bauelement **20** nach dem Stand der Technik. Ein Grat **19** an der der Bestückungsseite gegenüberliegenden Fläche, der in der Trennfläche des Mouldwerkzeugs beim Moulden zwischen den Gehäuseteilen **12a** und **12b** entsteht, verursacht einen Abstand zwischen der Saugnadel **18** und dem Gehäuse **12,** so dass das Bauelement **20** überhaupt nicht oder nur mit geringer Kraft und verkantet gehalten wird. Dies hat in unannehmbar vielen Fällen zur Folge, dass das Bauelement **20** eine gekippte Stellung an der Saugnadel **18** einnimmt, beispielsweise eine der dargestellten Miss-Stellungen **23** oder **24** und dadurch auf der Leiterplatte ungenau positioniert wird, was manuelle und somit teure Nacharbeit notwendig macht. Weiterhin ist oft die Folge, dass das Bauelement **20** nicht aufgenommen wird oder auf dem Transportweg verloren geht.

Die erfindungsgemäße Vorrichtung und das erfindungsgemäße Verfahren ermöglichen die gratfreie Herstellung von solchen Flächen eines elektronischen Bauelements, an der die Saugnadel einer Bestückungsmaschine andockt.

## Patentansprüche

1. Leiterstreifenanordnung für ein gemouldetes elektronisches Bauelement (11), bei der auf einem elektrisch leitfähigen Leiterstreifen (1) wenigstens ein Halbleiterbauelement (5a-c) angeordnet ist und bei der um den Leiterstreifen (1) und das wenigstens eine Halbleiterbauelement (5a-c) ein Gehäuse (12) aus einem Mouldwerkstoff derart angeordnet ist, dass sich noch Teile (8) des Leiterstreifens (1) außerhalb des Gehäuses (12) befinden, **dadurch gekennzeichnet, dass** Teile (8.1) des Leiterstreifens (1) eine Verbreiterung (10) aufweisen, so dass diese verbreiterten Teile (8.1) des Leiterstreifens (1) an das spätere Gehäuse (12) direkt angrenzen oder etwas in das Gehäuse (12) hinein ragen, um am Gehäuse (12) die Bildung eines Grats (19) aus dem Mouldwerkstoff zu verhindern.

2. Leiterstreifenanordnung nach Anspruch 1, **dadurch gekennzeichnet, dass** die verbreiterten Teile (8, 8.1) des Leiterstreifens (1) Öffnungen (9) aufweisen.

3. Leiterstreifenanordnung nach Anspruch 1 oder 2, **dadurch gekennzeichnet, dass** zwischen den Öffnungen (9) Stege (21) angeordnet sind.

4. Leiterstreifenanordnung nach Anspruch 2 oder 3, **dadurch gekennzeichnet, dass** die Öffnungen (9) als Langlöcher ausgebildet sind.

5. Verfahren zum Moulden eines Gehäuses (12) eines elektronischen Bauelements (11) in einer Mouldform, wobei das Bauelement (1) einen elektrisch leitfähigen Leiterstreifen (1) und einseitig angeordnete Anschlussbeinchen (2) und der Leiterstreifen (1) einen Rahmen (8) mit Rahmenteilen (8.1, 8.2) aufweist, der zwischen Ober- und Unterteil der Mouldform die laterale Begrenzung bildet und dessen Durchmesser im wesentlichen geringfügig größer ist als der der eigentlichen Mouldform, **dadurch gekennzeichnet, dass** ein Rahmenteil (8.1) eine Verbreiterung (10) aufweist, der direkt an die Mouldform angrenzt bzw. etwas in die Mouldform hineinreicht, um die Bildung eines Grats (19) aus dem Mouldwerkstoff am Gehäuse (12) zu verhindern.

6. Verfahren nach Anspruch 5, **dadurch gekennzeichnet, dass** das wenigstens eine Halbleiterbauelement (5a-c) mittels eines Lotes oder eines leitfähigen Klebstoffes auf dem Leiterstreifen (1) befestigt wird.

7. Verfahren nach Anspruch 5 oder 6, **dadurch gekennzeichnet, dass** das wenigstens eine Halbleiterbauelement (5a-c) und der Leiterstreifen (1) mittels Bonddrähten (6) aus einer Aluminium- oder Goldlegierung elektrisch kontaktiert werden.

8. Verfahren nach einem der Ansprüche 5 bis 7, **dadurch gekennzeichnet, dass** das Gehäuse (12) aus einem für einen bestimmten Wellenlängenbereich transparenten Kunststoff hergestellt wird.

9. Verfahren nach einem der Ansprüche 5 bis 8, **dadurch gekennzeichnet, dass** in einem weiteren Fertigungsschritt die bis direkt an das Gehäuse (12) reichende oder etwas in das Gehäuse (12) hinein ragende Verbreiterung (10) des Leiterstreifens (1) mechanisch verformt und dadurch vom oder aus dem Gehäuse (12) entfernt wird.

10. Verfahren nach Anspruch 9, **dadurch gekennzeichnet, dass** die mechanische Verformung des Leiterstreifenteils (8.1) durch Prägen einer Verformung (16) erfolgt.

11. Verfahren nach Anspruch 10, **dadurch gekennzeichnet, dass** das Prägen der Verformung (16) durch Einbringen von Öffnungen (9) in die Teile (8.1) des Leiterstreifens (1) erleichtert wird.

12. Verfahren nach einem der Ansprüche 9 bis 11, **dadurch gekennzeichnet, dass** als Verformung (16) eine Sicke hergestellt wird.

13. Verfahren nach einem der Ansprüche 9 bis 12, **dadurch gekennzeichnet, dass** als Verformung (16) eine V-förmige Sicke hergestellt wird.
